# EUROPEAN PATENT APPLICATION

(11) **EP 4 709 058 A1**
(43) Date of publication of application: **11.03.2026**
(21) Application number: 24819565.3
(22) Date of filing: 05.06.2024
(51) Int. Cl.: H05K 1/02, H03H 7/38, H05K 1/14, H04M 1/02, H04M 1/72448

(54) **ELECTRONIC DEVICE AND NOISE CONTROL METHOD**

(30) Priority: 05.06.2023 KR 20230072154; 24.07.2023 KR 20230095894
(71) Applicant: Samsung Electronics Co., Ltd., Suwon-si, Gyeonggi-do 16677 (KR)
(72) Inventor: JANG, Seokmin, Suwon-si, Gyeonggi-do 16677 (KR); LEE, Donghyeok, Suwon-si, Gyeonggi-do 16677 (KR); KIM, Moonyung, Suwon-si, Gyeonggi-do 16677 (KR); LEE, Wonho, Suwon-si, Gyeonggi-do 16677 (KR)
(74) Representative: Gulde & Partner
(86) International application number: PCT/KR2024/007672
(87) International publication number: WO 2024/253414

(57) **Abstract**

An electronic device of the present disclosure may include: a slidable housing including a first housing and a second housing; a first substrate included in the first housing and including a processor; a second substrate included in the second housing; an FPCB which includes a ground line, electrically connects the first substrate and the second substrate to each other, and has a shape changed according to the movement of the slidable housing; and a matching circuit electrically connecting the first substrate and at least a portion of the ground line of the FPCB, and changing impedance under the control of the processor according to the shape of the FPCB. Various other embodiments are possible.

## Description

### [Technical Field]

The disclosure relates to an electronic device and a noise control method.

### [Background Art]

Electronic devices are being developed to become increasingly slim with increased rigidity and enhanced design aspects while differentiating their functional elements. Electronic devices are evolving from uniform rectangular shapes to increasingly diverse forms. Electronic devices may have a deformable structure that is convenient to carry and allows the use of a large-screen display. Electronic devices may have a structure (e.g., a rollable structure or a slidable structure) that varies the display area of a flexible display through support of housings that operate in a sliding manner relative to each other.

### [Disclosure of Invention]

### [Technical Problem]

Electronic devices may include a rollable electronic device or a slidable electronic device configured such that the display area of a flexible display (e.g., a rollable display) can be expanded and/or reduced according to the operating state.

The rollable electronic device or slidable electronic device may include a first housing and a second housing coupled to be movable relative to each other while being at least partially fitted together. For example, the first housing and the second housing may operate to slide relative to each other and may support at least a part of a flexible display (e.g., a rollable display, an expandable display, or a stretchable display).

The rollable electronic device or slidable electronic device may include a first circuit board disposed in the first housing and a second circuit board disposed in the second housing.

The rollable electronic device or slidable electronic device may include a flexible printed circuit board (FPCB) or a flexible radio frequency cable (FRC) that can be deformed according to movements between the housings to electrically connect the first circuit board and the second circuit board.

However, the FPCB or FRC deformed according to movements between the housings may resonate with a frequency band in operation in the rollable electronic device at a specific length, thereby generating noise.

An electronic device and a noise control method according to an aspect of the disclosure include a matching circuit between the ground of an FPCB or FRC and a substrate such that noise is controlled.

An electronic device according to an embodiment of the disclosure may include a slidable housing including a first housing and a second housing.

The electronic device according to an embodiment of the disclosure may include a first substrate included in the first housing and including a processor, a second substrate included in the second housing, and a ground line.

The electronic device according to an embodiment of the disclosure may include an FPCB electrically connecting between the first substrate and the second substrate, and having a shape changed according to a movement of the slidable housing, and a matching circuit electrically connecting the first substrate and at least a part of the ground line of the FPCB, and having an impedance changed under the control of the processor according to a movement of at least a part of the housing.

A noise control method by an electronic device including a flexible printed circuit board (FPCB) having a shape changed according to movements of a slidable housing according to an embodiment of the disclosure may include: an operation of identifying an RF frequency band operating in the electronic device or communication processor; an operation of identifying information on the shape of the FPCB corresponding to movements of the slidable housing; an operation of identifying information on noises according to the shape of the FPCB corresponding to multiple RF frequencies, respectively; an operation of determining whether noises according to the shape of the FPCB overlap or resonate with the RF frequency band operating in the electronic device or the communication processor; and an operation of controlling the matching circuit to change the impedance of the matching circuit in case that noises according to the shape of the FPCB overlap or resonate with the RF frequency band operating in the electronic device or the communication processor.

An electronic device and a noise control method of the disclosure may include a matching circuit between the ground of an PFCB or FRC and a substrate such that radio frequencies can be transmitted/received without being affected by noise occurring in the FPCB or FRC.

Advantageous effects obtainable from the disclosure may not be limited to the above-mentioned effects, and other effects which are not mentioned herein may be clearly understood from the following description by those skilled in the art to which the disclosure pertains.

### [Brief Description of Drawings]

With regard to the description of the drawings, the same or like reference signs may be used to designate the same or like elements.
FIG. 1 is a block diagram of an electronic device in a network environment according to various embodiments of the disclosure.
FIG. 2A and FIG. 2B are drawings illustrating the front and rear sides of an electronic device in a slide-in state according to various embodiments of the disclosure.
FIG. 3A and FIG. 3B are drawings illustrating the front and rear sides of an electronic device in a slide-out state according to various embodiments of the disclosure.
FIG. 4 is an exploded perspective view of an electronic device according to an embodiment of the disclosure.
FIG. 5 is a diagram showing the electronic device in a state in which the rear bracket and the second support member are removed, and the first housing has slid inward in the second direction (direction ②).
FIG. 6 is a diagram showing the electronic device in a state in which the rear bracket and the second support member are removed, and the first housing has slid outward in the first direction (direction ①).
FIG. 7A is a diagram showing the first length of the flexible printed circuit board (FPCB) when the first housing sides inward in the second direction (direction ②).
FIG. 7B is a diagram showing the second length of the FPCB when the first housing sides outward in the first direction (direction ①).
FIG. 8 is a diagram schematically showing the connection of the first substrate, the matching circuit, and the FPCB in the electronic device.
FIG. 9 is a diagram showing the configuration of the FPCB according to an embodiment of the disclosure.
FIG. 10 is a block diagram of the first substrate, the matching circuit, and the FPCB according to an embodiment of the disclosure.
FIG. 11 is a flowchart of a noise control method by an electronic device according to an embodiment of the disclosure.

### [Mode for the Invention]

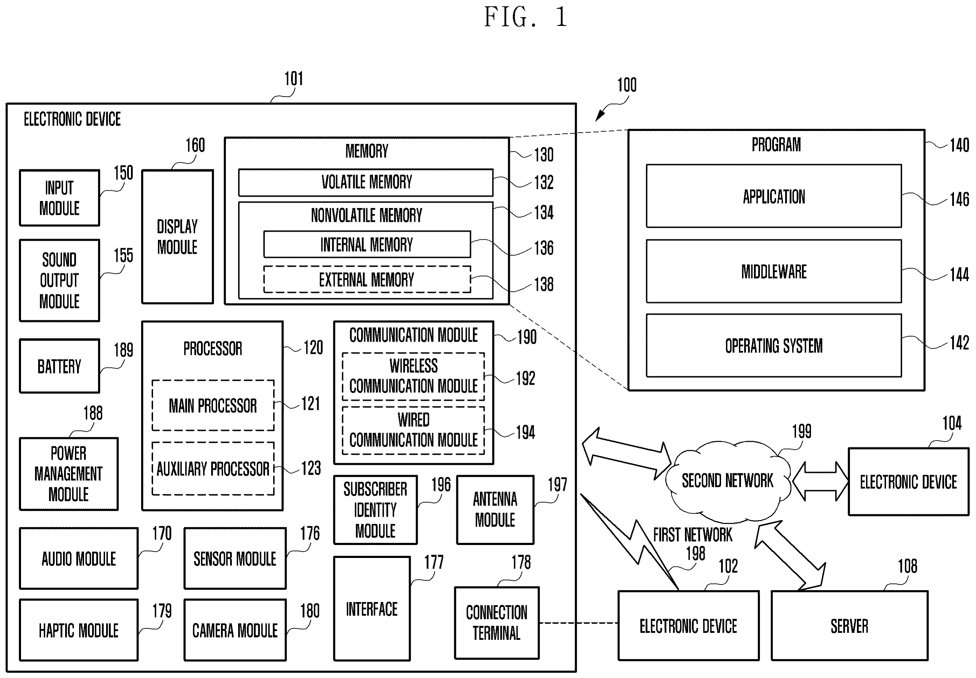

Fig. 1 is a block diagram illustrating an electronic device 101 in a network environment 100 according to various embodiments.

Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

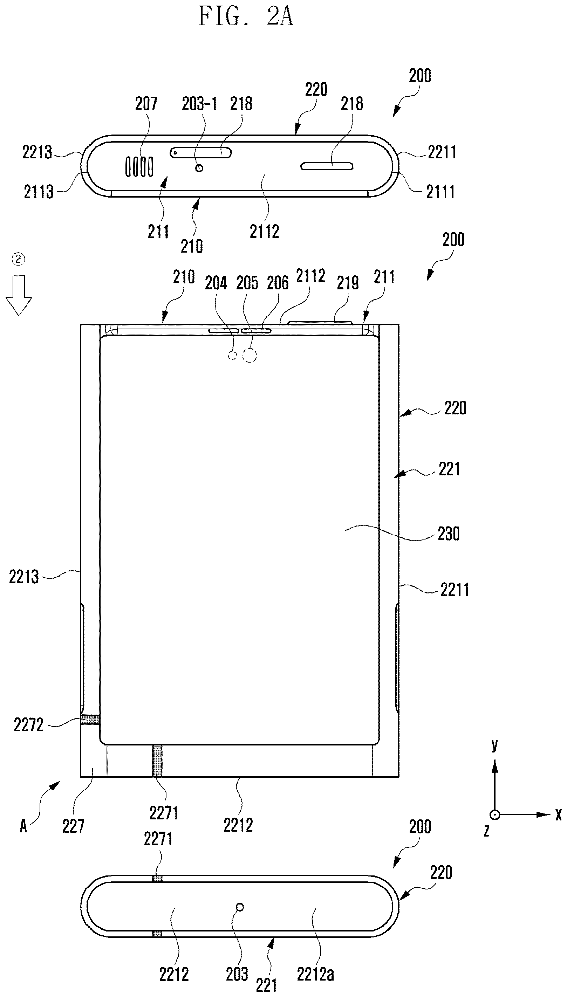

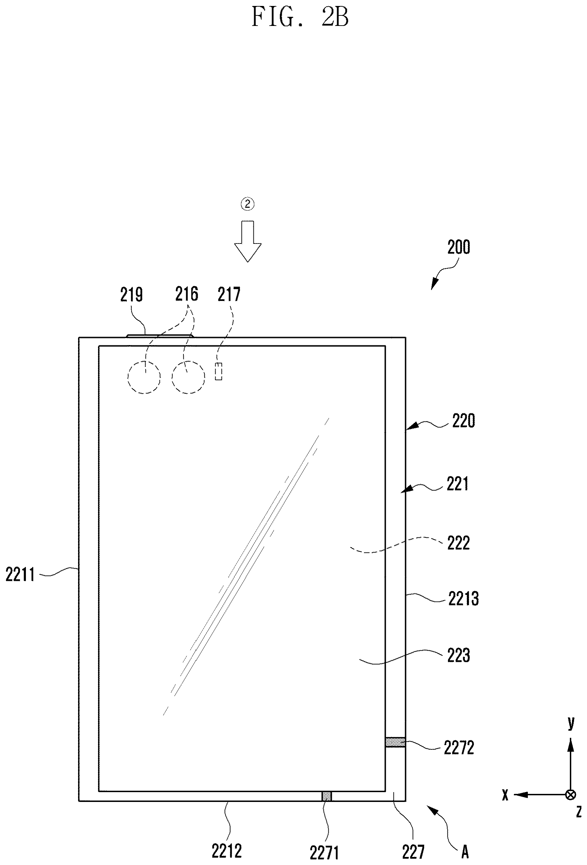

FIG. 2A and FIG. 2B are drawings illustrating the front and rear sides of an electronic device 200 in a slide-in state according to various embodiments of the disclosure.

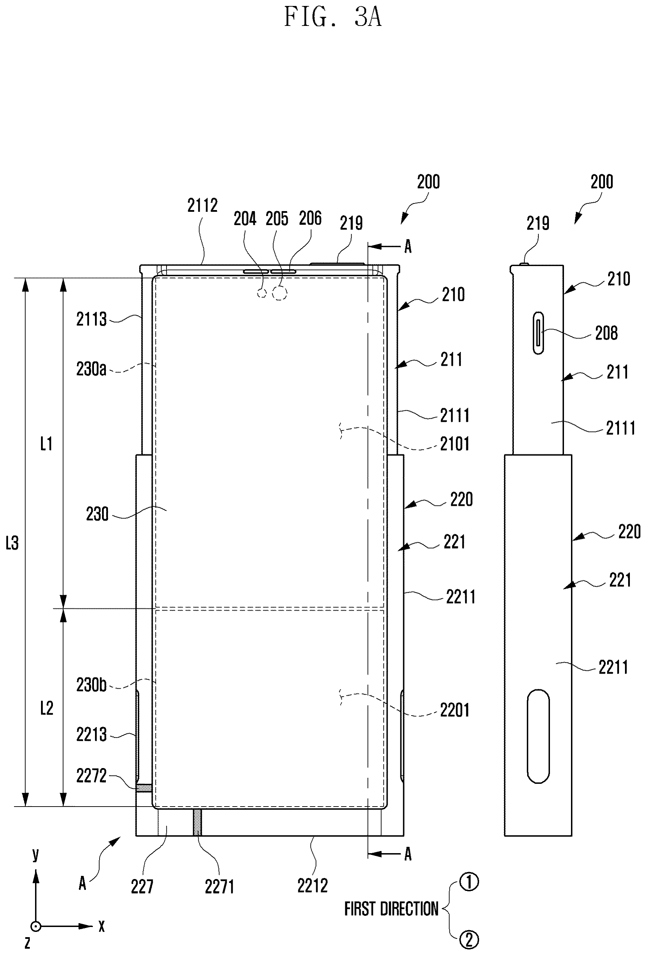

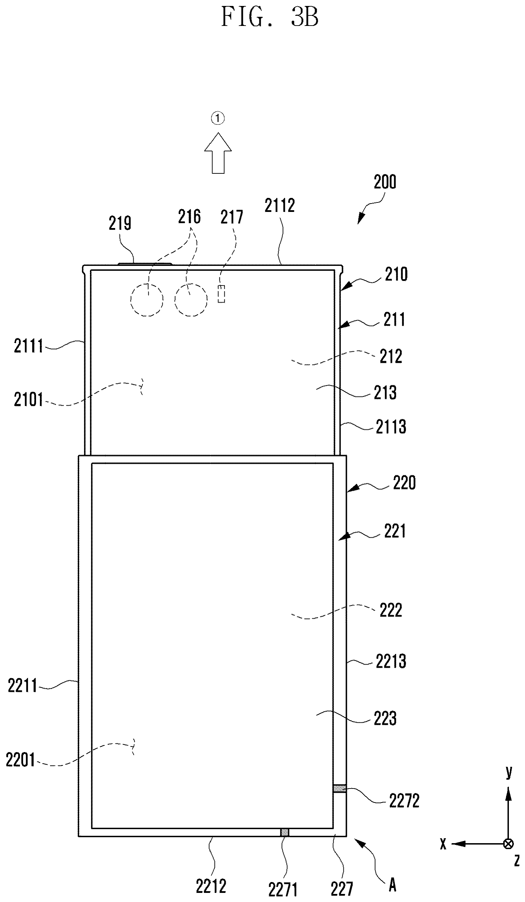

FIG. 3A and FIG. 3B are drawings illustrating the front and rear sides of an electronic device 200 in a slide-out state according to various embodiments of the disclosure.

The electronic device 200 of FIG. 2A to FIG. 3B may be at least partially similar to the electronic device 101 of FIG. 1, or may further include other embodiments of the electronic device.

Referring to FIG. 2A to FIG. 3B, the electronic device 200 may include a first housing 210 (e.g., a first housing structure, a movable portion, or a sliding housing), a second housing 220 (e.g., a second housing structure, a fixed portion, or a base housing) coupled to the first housing 210 to be able to slide in a specified direction (e.g., in direction ① or direction ②) (e.g., in the ±y-axis direction), and a flexible display 230 (e.g., an expandable display or a stretchable display) disposed to be supported through at least a part of the first housing 210 and the second housing 220.

In an embodiment, the first housing 210 and the second housing 220 may be movable relative to each other. The electronic device 200 may include a slidable housing or a rollable housing including the first housing 210 and the second housing 220.

In an embodiment, the electronic device 200 may be disposed such that the first housing 210 is slid outward in the first direction (direction ①) or slid inward in the second direction (direction ②) opposite to the first direction (direction ①), with reference to the second housing 220 gripped by the user.

In an embodiment, at least a part of the first housing 210, including a first space 2101, may be accommodated in a second space 2201 of the second housing 220, thereby being changed to a slide-in state.

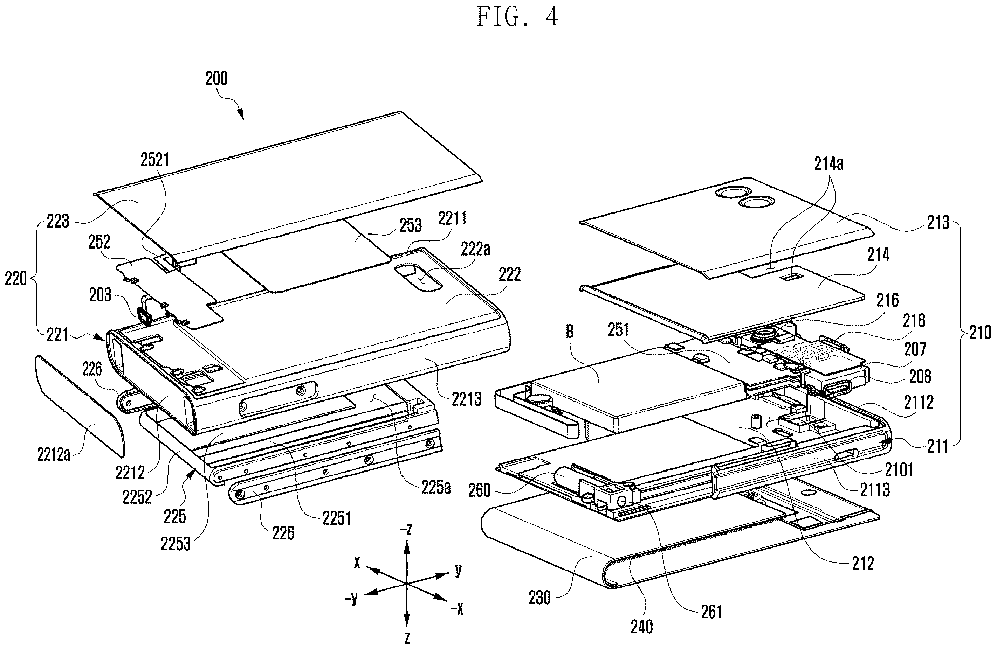

In an embodiment, the electronic device 200 may include a bendable member (or a bendable support member) (e.g., the bendable member 240 of FIG. 4) (e.g., a multi-joint hinge module or a multi-bar assembly) which, in a slide-out state, forms at least partially the same plane with at least a part of the first housing 210 and, in a slide-in state, is at least partially accommodated in the second space 2201 of the second housing 220.

In an embodiment, at least a part of the flexible display 230 may be disposed to be invisible from the outside by being accommodated in the internal space 2201 of the second housing 220 while being supported by a bendable member (e.g., the bendable member 240 of FIG. 4) in a slide-in state.

In an embodiment, at least a part of the flexible display 230 may be disposed to be visible from the outside while being supported by a bendable member (e.g., the bendable member 240 of FIG. 4) that forms at least partially the same plane with the first housing 210 in a slide-out state.

In an embodiment, the electronic device 200 may include a first housing 210 including a first side member 211 and a second housing 220 including a second side member 221.

In an embodiment, the first side member 211 may include a first side surface 2111 having a first length along the first direction (e.g., the y-axis direction), a second side surface 2112 extending from the first side surface 2111 along a substantially perpendicular direction (e.g., the x-axis direction) to have a second length shorter than the first length, and a third side surface 2113 extending from the second side surface 2112 substantially parallel to the first side surface 2111 and having the first length.

In an embodiment, the first side member 211 may be formed at least partially of a conductive material (e.g., a metal).

In an embodiment, the first side member 211 may be formed by a combination of a conductive material and a non-conductive material (e.g., a polymer).

In an embodiment, the first housing 210 may include a first support member 212 that extends from at least a part of the first side member 211 to at least a part of the first space 2101.

In an embodiment, the first support member 212 may be integrally formed with the first side member 211.

In an embodiment, the first support member 212 may be configured separately from the first side member 211 and may be structurally coupled to the first side member 211.

In an embodiment, the second side member 221 may include a fourth side surface 2211 that at least partially corresponds to the first side surface 2111 and has a third length, a fifth side surface 2212 that extends from the fourth side surface 2211 in a direction substantially parallel to the second side surface 2112 and has a fourth length shorter than the third length, and a sixth side surface 2213 that extends from the fifth side surface 2212 to correspond to the third side surface 2113 and has the third length.

In an embodiment, the second side member 221 may be formed at least partially of a conductive material (e.g., a metal).

In an embodiment, the second side member 221 may be formed by a combination of a conductive material and a non-conductive material (e.g., a polymer).

In an embodiment, at least a part of the second side member 221 may include a second support member 222 that extends to at least a part of the second space 2201 of the second housing 220.

In an embodiment, the second support member 222 may be integrally formed with the second side member 221.

In an embodiment, the second support member 222 may be configured separately from the second side member 221 and may be structurally coupled to the second side member 221.

In an embodiment, the second support member 222 may be formed at least partially of a conductive material (e.g., a metal).

In an embodiment, the second support member 222 may be formed by a combination of a conductive material and a non-conductive material (e.g., a polymer).

In an embodiment, the first side surface 2111 and the fourth side surface 2211 may be slidably coupled relative to each other.

In an embodiment, the third side surface 2113 and the sixth side surface 2213 may be slidably coupled relative to each other.

In an embodiment, in a slide-in state, the first side surface 2111 may be disposed to be substantially invisible from the outside by overlapping with the fourth side surface 2211.

In an embodiment, in a slide-in state, the third side surface 2113 may be disposed to be substantially invisible from the outside by overlapping with the sixth side surface 2213.

In an embodiment, at least a part of the first side surface 2111 and the third side surface 2113 may be disposed to be at least partially visible from the outside in a slide-in state.

In an embodiment, in a slide-in state, the first support member 212 may be disposed to be substantially invisible from the outside by overlapping with the second support member 222.

In an embodiment, a part of the first support member 212 may be disposed to be invisible from the outside by overlapping with the second support member 222 in a slide-in state, and a remaining part of the first support member 212 may be disposed to be visible from the outside.

In an embodiment, the electronic device 200 may include a first rear cover 213 coupled to the first housing 210 on the rear surface.

In an embodiment, the first rear cover 213 may be disposed through at least a part of the first support member 212.

In an embodiment, the first rear cover 213 may be integrally formed with the first side member 211.

In an embodiment, the first rear cover 213 may be formed by a polymer, coated or colored glass, ceramic, metal (e.g., aluminum, stainless steel (STS), or magnesium), or a combination of at least two of these materials.

In an embodiment, the first rear cover 213 may extend to at least a part of the first side member 211.

In an embodiment, at least a part of the first support member 212 may be replaced by the first rear cover 213.

In an embodiment, the electronic device 200 may include a second rear cover 223 coupled to the second housing 220 on the rear surface.

In an embodiment, the second rear cover 223 may be disposed through at least a part of the second support member 222.

In an embodiment, the second rear cover 223 may be integrally formed with the second side member 221.

In an embodiment, the second rear cover 223 may be formed by a polymer, coated or colored glass, ceramic, metal (e.g., aluminum, stainless steel (STS), or magnesium), or a combination of at least two of these materials.

In an embodiment, the second rear cover 223 may extend to at least a part of the second side member 221.

In an embodiment, at least a part of the second support member 222 may be replaced by the second rear cover 223.

In an embodiment, the electronic device 200 may include a flexible display 230 disposed to be supported by at least a part of the first housing 210 and the second housing 220.

In an embodiment, the flexible display 230 may include a first portion 230a (e.g., a flat portion) that is always visible from the outside and a second portion 230b (e.g., a bendable portion) that extends from the first portion 230a and is at least partially accommodated in the second space 2201 of the second housing 220 such that at least a part thereof is not visible from the outside in a slide-in state.

In an embodiment, the first portion 230a may be disposed to be supported by the first housing 210, and the second portion 230b may be disposed to be supported at least partially by a bendable member (e.g., the bendable member 240 of FIG. 4).

In an embodiment, the second portion 230b of the flexible display 230 may be disposed to extend from the first portion 230a while being supported by a bendable member (e.g., the bendable member 240 of FIG. 4), to form substantially the same plane with the first portion 230a and to be visible from the outside, in a state where the first housing 210 is slid out along the first direction (direction ①).

In an embodiment, the second portion 230b of the flexible display 230 may be accommodated in the second space 2201 of the second housing 220 and disposed to be invisible from the outside in a state where the second housing 220 is slid inward along the second direction (direction ②). Therefore, the electronic device 200 may induce variation in the display area of the flexible display 230 as the first housing 210 moves in a sliding manner along a specified direction (e.g., the ±y-axis direction) from the second housing 220.

In an embodiment, the length (or shape) of the flexible display 230 in the first direction (direction ①) may vary according to a sliding movement of the first housing 210 that moves with reference to the second housing 220. For example, the flexible display 230 may have a first display area (e.g., a region corresponding to the first portion 230a) corresponding to a first length L1 of the flexible display 230 in a slide-in state.

In an embodiment, in a slide-out state, the flexible display 230 may be expanded to have a third display area (e.g., a region including the first portion 230a and the second portion 230b) that is larger than the first display area and corresponds to a third length L3 of the flexible display 230 that is longer than the first length L1 of the flexible display 230, according to a sliding movement of the first housing 210 that is additionally moved by a second length L2 of the flexible display 230 with reference to the second housing 220.

In an embodiment, the electronic device 200 may include at least one of an input device (e.g., a microphone 203-1) disposed in the first space 2101 of the first housing 210, a sound output device (e.g., a receiver 206 for calls or a speaker 207), sensor modules 204 and 217, a camera module (e.g., a first camera module 205 or a second camera module 216), a connector port 208, a key input device 219, or an indicator (not shown).

In an embodiment, the electronic device 200 may include another input device (e.g., a microphone 203) disposed in the second housing 220. In another embodiment, the electronic device 200 may be configured such that at least one of the aforementioned components is omitted or other components are additionally included. In another embodiment, at least one of the aforementioned components may be disposed in the second space 2201 of the second housing 220.

In an embodiment, the input device may include a microphone 203-1.

In an embodiment, the input device (e.g., the microphone 203-1) may include multiple microphones disposed to detect the direction of sounds. The sound output device may include, for example, a receiver 206 for calls and a speaker 207.

In an embodiment, the speaker 207 may correspond to the outside through at least one speaker hole formed in the first housing 210 at a location (e.g., on the second side surface 2112) always exposed to the outside regardless of the slide-in/slide-out state.

In an embodiment, the connector port 208 may correspond to the outside through a connector port hole formed in the first housing 210 in a slide-out state.

In an embodiment, in a slide-in state, the connector port 208 may correspond to the outside through an opening formed in the second housing 220 and configured to correspond to the connector port hole.

In an embodiment, the receiver 206 for calls may include a speaker (e.g., a piezo speaker) that operates without a separate speaker hole. The receiver 206 for calls may be replaced by the speaker 207, and the electronic device 200 may include multiple speakers 207.

In an embodiment, the sensor modules 204 and 217 may generate electrical signals or data values corresponding to internal operating states of the electronic device 200 or external environmental states. The sensor modules 204 and 217 may include, for example, a first sensor module 204 (e.g., a proximity sensor or an illuminance sensor) disposed on the front surface of the electronic device 200 and/or a second sensor module 217 (e.g., a heart rate monitoring (HRM) sensor) disposed on the rear surface of the electronic device 200.

In an embodiment, the first sensor module 204 may be disposed under the flexible display 230 on the front surface of the electronic device 200.

In an embodiment, the first sensor module 204 and/or the second sensor module 217 may include at least one of a proximity sensor, an illuminance sensor, a time of flight (TOF) sensor, an ultrasonic sensor, a fingerprint recognition sensor, a gesture sensor, a gyro sensor, a barometric sensor, a magnetic sensor, an acceleration sensor, a grip sensor, a color sensor, an infrared (IR) sensor, a biometric sensor, a temperature sensor, or a humidity sensor.

In an embodiment, the camera module may include a first camera module 205 disposed on the front surface of the electronic device 200 and a second camera module 216 disposed on the rear surface of the electronic device 200. According to an embodiment, the electronic device 200 may include a flash (not shown) located near the second camera module 216.

In an embodiment, the camera modules 205 and 216 may include one or multiple lenses, an image sensor, and/or an image signal processor.

In an embodiment, the first camera module 205 may be disposed under the flexible display 230 and may be configured to capture a subject through a part of an active region (e.g., a display region) of the flexible display 230.

In an embodiment, the first camera module 205 among the camera modules and some sensor modules 204 among the sensor modules 204 and 217 may be disposed to detect external environments through the flexible display 230. For example, the first camera module 205 or some sensor modules 204 may be disposed in the first space 2101 of the first housing 210 to contact external environments through a transmission region formed in the flexible display 230 or an opening perforated therein.

In an embodiment, a region of the flexible display 230 facing the first camera module 205 may be formed as a transmission region having a specified transmittance as a part of a display region for displaying content.

In an embodiment, the transmission region may be formed to have a transmittance in a range of about 5% to about 20%. The transmission region may include a region overlapping the effective region (e.g., the field-of-view region) of the first camera module 205 such that light passes therethrough and forms an image on an image sensor. For example, the transmission region of the flexible display 230 may include a region having a lower pixel arrangement density and/or wiring density than surroundings. For example, the transmission region may replace the aforementioned opening. For example, some camera modules 205 may include an under display camera (UDC). In some embodiments, some sensor modules 204 may be disposed in the internal space of the electronic device 200 to perform their functions without being visually exposed through the flexible display 230.

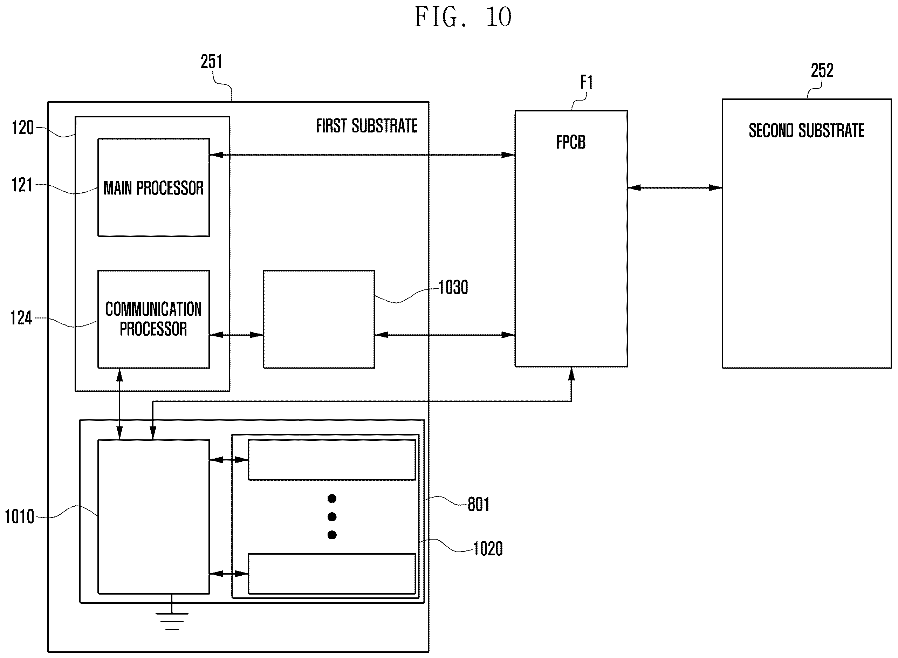

In an embodiment, the electronic device 200 may include at least one antenna (e.g., the antenna 214b of FIG. 10) electrically connected to a wireless communication circuit (e.g., the wireless communication module 192 of FIG. 1) disposed in the second housing 220.

In an embodiment, the electronic device 200 may include an antenna A using a metal frame disposed through the conductive second side member 221 of the second housing 220. For example, the antenna A using a metal frame may be disposed on at least a part of the fifth side surface 2212 and the sixth side surface 2213 of the second side member 221, and may include a conductive portion 227 electrically segmented through at least one segmented portion 2271 and 2272 formed of a non-conductive material (e.g., a polymer).

In an embodiment, the wireless communication circuit (e.g., the wireless communication module 192 of FIG. 1) may be configured to transmit or receive radio signals in at least one specified frequency band (e.g., about 800 MHz to 6000 MHz) (e.g., a legacy band) through the conductive portion 227. According to an embodiment, the electronic device 200 may include a side cover 2212a disposed on the fifth side surface 2212 to cover at least a part of at least one segmented portion 2271. In some embodiments, the antenna A using a metal frame may be disposed on at least one of the second side surface 2112, the fourth side surface 2211, the fifth side surface 2212, or the sixth side surface 2213.

In an embodiment, the electronic device 200 may further include at least one antenna module (e.g., a 5G antenna module or an antenna structure) disposed in the internal space (e.g., the first space 2101 or the second space 2201) and configured to transmit or receive radio signals in a frequency band in a range of about 3 GHz to 100 GHz through another wireless communication circuit (e.g., the wireless communication module 192 of FIG. 1).

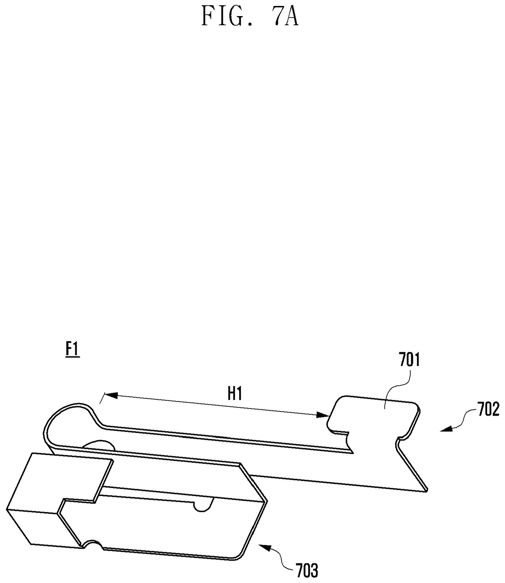

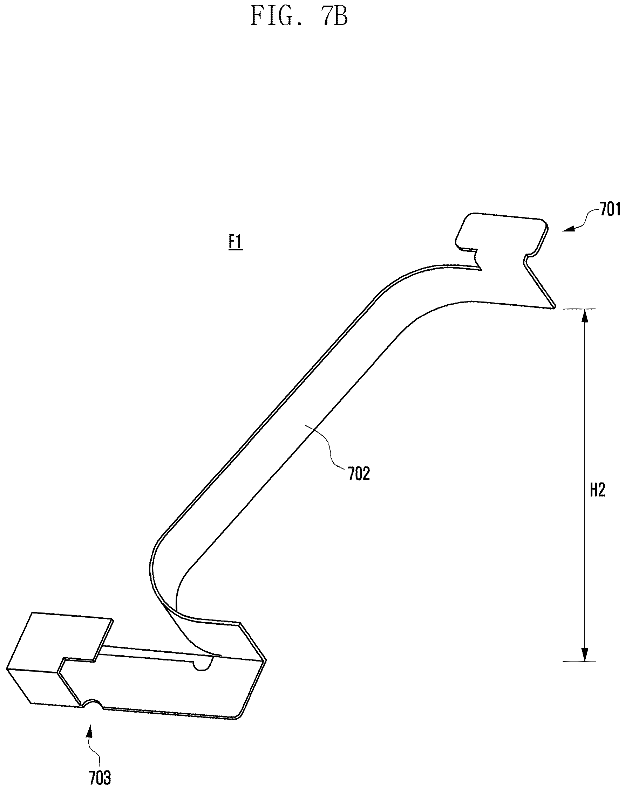

In an embodiment, the slide-in/slide-out operation of the electronic device 200 may be performed automatically. For example, the slide-in/slide-out operation of the electronic device 200 may be performed through a gearing operation of a pinion gear (e.g., the pinion gear 261 of FIG. 7), a drive motor (e.g., the drive motor 260 of FIG. 4), and a rack gear (e.g., the rack gear 2251 of FIG. 4) gear-coupled to the pinion gear 261. For example, the processor (e.g., the processor 120 of FIG. 1) of the electronic device 200 may operate a drive motor (e.g., the drive motor 260 of FIG. 4) disposed inside the electronic device 200 in case of detecting a triggering operation for changing from a slide-in state to a slide-out state or from a slide-out state to a slide-in state.

In an embodiment, the triggering operation may include selecting (e.g., touching) an object displayed on the flexible display 230 or manipulating a physical button (e.g., a key button) included in the electronic device 200.

The electronic device 200 according to exemplary embodiments of the present disclosure may provide an extended sliding distance (stroke) by having a design structure in which a drive motor (e.g., the drive motor 260 of FIG. 4) is disposed at an end in the slide-in direction (direction ②) (e.g., at the upper end of the second housing 220 in the slide-in state), and a pinion gear (e.g., the pinion gear 261 of FIG. 7) of the drive motor 260 moves along a rack gear (e.g., the rack gear 2251 of FIG. 4) (e.g., a structure in which the drive motor 260 is disposed at the upper end of the second housing 220 in the slide-in state).

FIG. 4 is an exploded perspective view of an electronic device according to an embodiment of the disclosure.

In describing the electronic device 200 of FIG. 4, the same reference numerals are assigned to components substantially identical to those of the electronic device 200 of FIG. 2A to FIG. 3B, and detailed descriptions thereof may be omitted.

Referring to FIG. 4, the electronic device 200 may include a first housing 210 including a first space 2101, a second housing 220 that is slidably coupled to the first housing 210 and includes a second space (e.g., the second space 2201 of FIG. 3A), a bendable member 240 disposed to be at least partially rotatable in the second space 2201, a flexible display 230 disposed to be supported by at least a part of the bendable member 240 and by the first housing 210, and a drive module configured to drive the first housing 210 in a direction in which the tends to slide into the second housing 220 (e.g., in the -y-axis direction) and/or in a direction in which the tends to slide out of the same (e.g., in the y-axis direction). According to an embodiment, the drive module may include a drive motor 260 disposed in the first space 2101 and including a pinion gear, and a rack gear 2251 disposed in the second space 2201 and gear-coupled to the pinion gear. According to an embodiment, the drive module may further include a reduction module coupled to the drive motor 260 so as to reduce the rotation speed and increase the driving force. According to an embodiment, the drive motor 260 may be disposed in the first space 2101 of the first housing 210 to be supported through at least a part of the first support member 212. According to an embodiment, the drive motor 260 may be fixed to an end (e.g., an edge) of the first support member 212 in the first space 2101 in the slide-in direction (e.g., in the -y-axis direction).

According to an embodiment, the electronic device 200 may include multiple electronic components disposed in the first space 2101. According to an embodiment, the multiple electronic components may include a first substrate 251 (e.g., a main substrate), a camera module 216 disposed around the first substrate 251, a socket module 218 (e.g., a SIM tray), a speaker 207, a connector port 208, and a battery B. According to an embodiment, the multiple electronic components may be disposed around the first substrate 251 in the first space 2101 of the first housing 210 together with the drive motor 260, thereby enabling efficient electrical connection.

According to an embodiment, the electronic device 200 may include a rear bracket 214 disposed between the first support member 212 and the first rear cover 213 of the first housing 210 to cover at least some of multiple electronic components. According to an embodiment, the rear bracket 214 may be structurally coupled to at least a part of the first support member 212. In an embodiment, the rear bracket 214 may be omitted. According to an embodiment, the rear bracket 214 may be disposed to cover multiple electronic components and to support the first rear cover 213. According to an embodiment, the rear bracket 214 may include a notch region 214a or an opening 214a (e.g., a through-hole) formed in a region corresponding to the camera module 216 and/or a sensor module (e.g., the sensor module 217 of FIG. 3B). According to an embodiment, the camera module 216 and/or the sensor module 217 may be disposed to detect external environments through the notch region 214a or the opening 214a. According to an embodiment, the first rear cover 213 may have at least a region which corresponds to the camera module 216 and/or the sensor module 217, and which is made transparent. In an embodiment, the camera module 216 and/or the sensor module 217 may be configured to operate only when the electronic device 200 is in a slide-out state.

According to an embodiment, the electronic device 200 may include a plate-type support bracket 225 (e.g., a display support bar (DSB)) disposed in the second space 2201 of the second housing 220 and slidably coupled to at least a part of the first support member 212. According to an embodiment, the support bracket 225 may include an opening 225a of a specified size. According to an embodiment, the support bracket 225 may include a support portion 2252 disposed at one end thereof and having an outer surface formed in a curved shape to support the rear surface of the bendable member 240 that bends during a sliding operation. According to an embodiment, the support bracket 225 may include a support plate 2253 formed to support the rear surface of the bendable member 240 in a slide-out state by extending from at least a part of the support portion 2252 to at least a part of the opening 225a. According to an embodiment, the support bracket 225 may include a rack gear 2251 fixed to have a length along a direction parallel to the sliding direction, while extending across the opening 225a. In an embodiment, the rack gear 2251 may be integrally formed with the support bracket 225. According to an embodiment, the electronic device 200 may include a pair of guide rails 226 disposed on both side surfaces of the support bracket 225 to guide both ends of the bendable member 240 in the sliding direction.

According to an embodiment, the second housing 220 may include an opening 222a (e.g., a through-hole) disposed in the second support member 222 in a region corresponding to the camera module 216 and/or the sensor module 217 disposed in the first housing 210 when the electronic device 200 is in a slide-in state. According to an embodiment, the camera module 216 and/or the sensor module 217 may detect external environments through the opening 222a formed in the second housing 220 when the electronic device 200 is in a slide-in state. In this case, at least the region of the second rear cover 223, which corresponds to the camera module 216 and/or the sensor module 217, may be made transparent.

According to an embodiment, the electronic device 200 may include a second substrate 252 (e.g., a sub-substrate) and an antenna member 253 disposed in a space between the second support member 222 and the second rear cover 223 of the second housing 220. According to an embodiment, the second substrate 252 and the antenna member 253 may be electrically connected to the first substrate 251 through at least one FPCB (e.g., a flexible printed circuit board) or FRC (flexible RF cable). In an embodiment, the antenna member 253 may be electrically connected to the second substrate 252 and thereby electrically connected to the first substrate 251 through the second substrate 252.

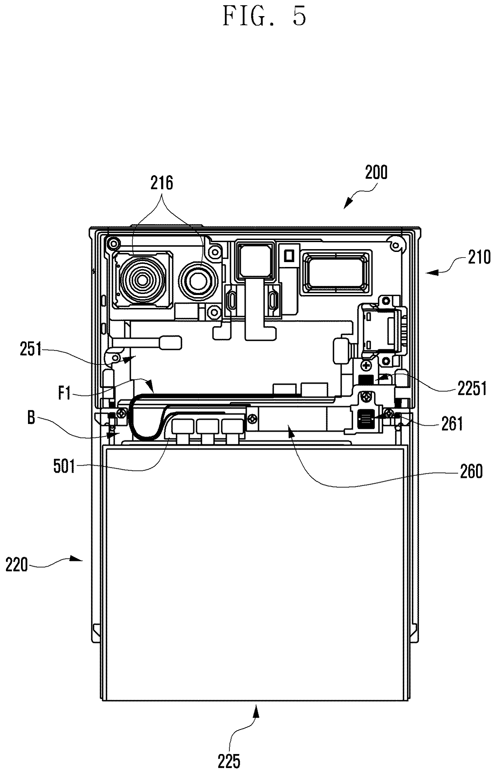

FIG. 5 is a diagram showing the electronic device 200 in a state in which the first rear cover 213, the rear bracket 214, and the second support member 222 are removed, and the first housing 210 has slid inward in the second direction (direction ②).

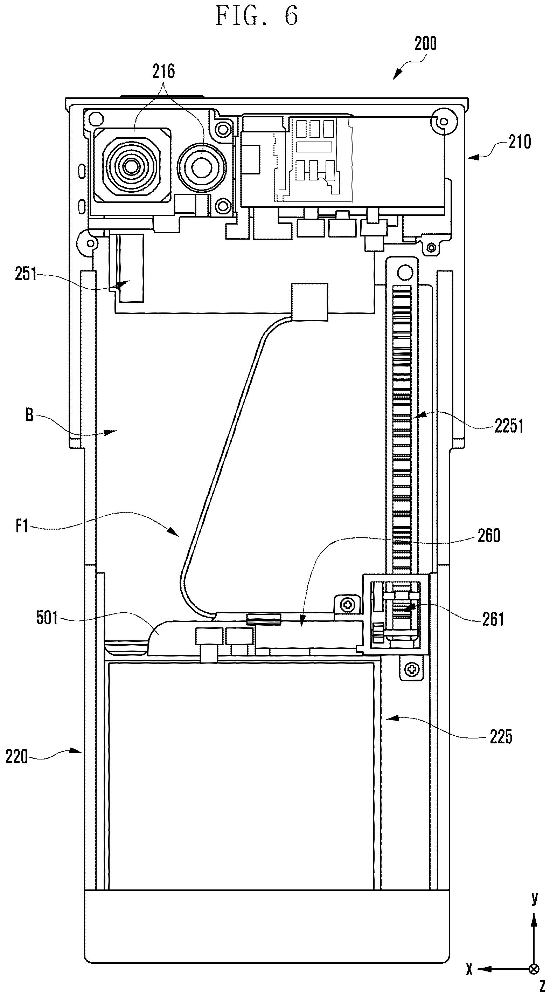

FIG. 6 is a diagram showing the electronic device 200 in a state in which the first rear cover 213, the rear bracket 214, and the second support member 222 are removed, and the first housing 210 has slid outward in the first direction (direction ①).

In describing the electronic device 200 of FIG. 5 and FIG. 6, the same reference numerals are assigned to substantially identical components as those in FIG. 2A to FIG. 3B and FIG. 4, and detailed descriptions thereof may be omitted.

Referring to FIG. 5 and FIG. 6, the configuration of the electronic device 200 will now be described.

In an embodiment, by removing the first rear cover 213, the rear bracket 214, and the second support member 222, at least a part of the first substrate 251, at least a part of the camera module 216, at least a part of the battery B, the drive motor 260, the pinion gear 261, the rack gear 2251, and at least a part of the support bracket 225 of the electronic device 200 may be exposed to the outside.

In an embodiment, the electronic device 200 may include a third substrate 501. The third substrate 501 may be a substrate that electrically connects the first substrate 251 and the second substrate 252. The third substrate 501 may electrically connect the first substrate 251, the second substrate 252 of FIG. 4, and/or the antenna member 253 of FIG. 4 through a flexible printed circuit board (FPCB) F1. However, this is not limitative, and the electronic device 200 may electrically connect the first substrate 251 and the second substrate 252 through the FPCB F1 without the third substrate 501.

In an embodiment, the FPCB F1 may electrically connect the first substrate 251, the second substrate 252, and/or the antenna member 253.

In an embodiment, the first substrate 251 and/or the second substrate 252 may include a ground.

In an embodiment, at least a part of the first substrate 251 and/or the second substrate 252 may be electrically connected to an antenna. The second substrate 252 of FIG. 4 may be connected to the antenna A through an antenna contact, and may be electrically connected to the third substrate 501 through an FPCB 2521 extending to the second substrate 252.

In an embodiment, the FPCB F1 may be disposed to have a length or a shape that accommodates the sliding distance of the electronic device 200.

In an embodiment, the FPCB F1 may be formed in a shape or of a material having elasticity such that the same expands in a slide-out state and restores to the original position in a slide-in state.

In an embodiment, the FPCB F1 may be replaced with a flexible RF cable (FRC).

In an embodiment, the FPCB F1 may be replaced with a flexible, deformable, and electrically connectable member.

FIG. 7A is a diagram showing the first length H1 of the FPCB F1 when the first housing 210 sides inward in the second direction (direction ②).

FIG. 7B is a diagram showing the second length H2 of the FPCB F1 when the first housing 210 sides outward in the first direction (direction ①).

Referring to FIG. 7A and FIG. 7B, the first length H1 and second length H2 may represent the distance between the first connector 701 and the second connector 703. The distance between the first connector 701 and the second connector 703 may vary according to the distance between the first housing 210 and the second housing 220. The first housing 210 and second housing 220 are movable, and the first connector 701 and second connector 703 may electrically connect the first substrate 251 and the second substrate 252 or the third substrate 253, included in each housing. The distance between the first connector 701 and the second connector 703 may vary according to the movement of the first housing 210 and second housing 220.

In an embodiment, the FPCB F1 may include a first connector 701, a transmission line 702, and a second connector 703.

In an embodiment, the first connector 701 may be electrically connected to the first substrate 251, and the second connector 703 may be electrically connected to the second substrate 252 and/or the third substrate 501.

In an embodiment, the transmission line 702 may include a signal line for transmitting radio signals, a signal line for transmitting logic signals, and a ground line.

In an embodiment, the FPCB F1 may electrically connect the first substrate 251 and the second substrate 253 through the first connector 701, the transmission line 702, and the second connector 703. Electronic components such as the processor 120 and communication module 190 disposed on the first substrate 251 and the second substrate 253 may exchange radio frequency (RF) signals and/or data signals through the FPCB F1.

In an embodiment, the shape of the transmission line 702 and/or the FPCB F1 may be changed by movements of the first housing 210 and/or second housing 220. For example, in a state where at least a part of the first housing 210 has slid into the second housing 220, the length (or shape) of the transmission line 702 and/or FPCB F1 may be the first length H1. In a state where at least a part of the first housing 210 has slid out of the second housing 220, the length (or shape) of the transmission line 702 and/or FPCB F1 may be the second length H2.

The length of the FPCB F1 of the disclosure may refer to a length corresponding to one of the distance values between the first connector 701 and the second connector 703. For example, as the first housing 210 and/or second housing 220 move, the distance between the first connector 701 and second connector 703 coupled to the substrates included in respective housings may change, and the length of the FPCB F1 may be one of the distance values between the first connector 701 and the second connector 703.

In an embodiment, the electronic device 200 may store information on the length (or shape) of the transmission line 702 and/or FPCB F1 corresponding to movements of the first housing 210 and/or second housing 220 in the memory 130.

In an embodiment, harmonic frequency components having properties similar to the RF frequency operating in the electronic device 200 may be generated as noise due to the length (or shape) of the FPCB F1. For example, assuming that the wavelength of the RF signal transmitted through the FPCB F1 is a [λ] (λ=c/f, c is the speed of light, and f is the frequency), noise may be generated if a multiple of a [λ] matches the first length H1 or second length H2. The length (or shape) of the FPCB F1 may be a length corresponding to one of the distance values between the first connector 701 and the second connector 703.

In an embodiment, the electronic device 200 may include information on multiple RF frequencies available in the electronic device 200 in the memory 130.

In an embodiment, the electronic device 200 may include information on harmonic frequency components caused by the length (or shape) of the transmission line 702 and/or the FPCB F1 corresponding to each of multiple RF frequencies available in the electronic device 200 in the memory 130.

In an embodiment, the electronic device 200 may store information on noises caused by the length (or shape) of the transmission line 702 and/or the FPCB F1 corresponding to each of multiple RF frequencies available in the electronic device 200 in the memory 130.

In an embodiment, information on harmonic frequency components caused by the length (or shape) of the transmission line 702 and/or the FPCB F1 may be identical to information on noises caused by the length (or shape) of the transmission line 702 and/or the FPCB F1. The length (or shape) of the FPCB F1 may be a length corresponding to one of the distance values between the first connector 701 and the second connector 703.

In an embodiment, the electronic device 200 may change the impedance of the FPCB F1 by controlling a matching circuit, based on information on noises corresponding to each of multiple RF frequencies.

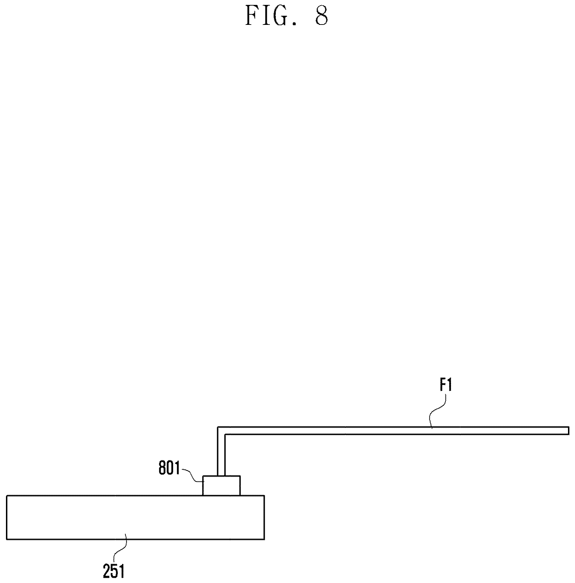

FIG. 8 is a diagram schematically showing the connection of the first substrate 251, the matching circuit 801, and the FPCB F1 in the electronic device 200.

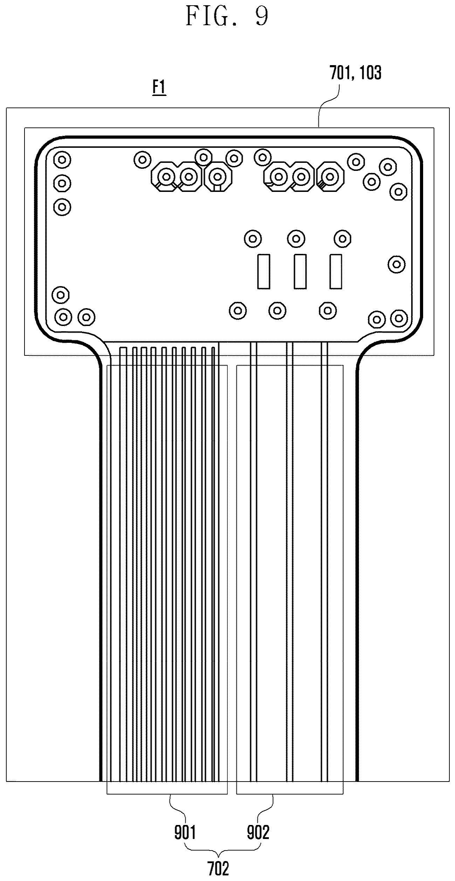

FIG. 9 is a diagram showing the configuration of the FPCB F1 according to an embodiment of the disclosure.

Referring to FIG. 8 and FIG. 9, the matching circuit (or matching circuitry) 801 may be included in at least a part of the first substrate 251 and may be disposed between the first substrate 251 and the first connector 701. However, it is not limitative, and the matching circuit 801 may be included in at least a part of the second substrate 252 and may be disposed between the second substrate 252 and the second connector 703.

In an embodiment, the electronic device 200 may include multiple matching circuits. Each of the multiple matching circuits may be included in at least a part of the first substrate 251 and at least a part of the second substrate 252, and may be disposed between the first substrate 251 and the first connector 701 and between the second substrate 252 and the second connector 703.

In an embodiment, the FPCB F1 may include a first connector 701, a transmission line 702, and a second connector 703. The transmission line 702 may include a signal line for transmitting logic signals and a ground line 901, and a radio signal line 902 for transmitting radio signals.

In an embodiment, the first connector 701 may include a ground pin (PIN). The first connector 701 may electrically connect the matching circuit 801 and the FPCB F1.

In an embodiment, the second connector 703 may include a ground pin. The second connector 703 may electrically connect the matching circuit 801 and the FPCB F1.

FIG. 10 is a block diagram of a first substrate 251, a matching circuit 801, and an FPCB F1 according to an embodiment of the disclosure.

In an embodiment, the electronic device 200 may include a first substrate 251, a matching circuit 801, and an FPCB F1.

In an embodiment, the first substrate 251 may include a processor 120, a matching circuit 801, and a radio frequency (RF) front end module 1030.

In an embodiment, the processor 120 may include a main processor 121 and a communication processor 124. The main processor 121 may be an application processor. The main processor 121 may exchange signals with electronic components included in the second substrate 262 through the signal line (e.g., 901 of FIG. 9) of the FPCB F1. The auxiliary processor 123 may exchange RF signals through the RF front end module 1030. The RF front end module 1030 may exchange RF signals with electronic components included in the second substrate 262 through the radio signal line (e.g., 902 of FIG. 9) of the FPCB F1. However, it is not limitative, and the communication processor 124 may exchange RF signals with electronic components included in the second substrate 262 through the radio signal line (e.g., 902 of FIG. 9) of the FPCB F1.

In an embodiment, the FPCB F1 may be electrically connected to the matching circuit 801. The ground line (e.g., 901 of FIG. 9) of the FPCB F1 may be electrically connected to the matching circuit 801.

In an embodiment, the matching circuit 801 may be electrically connected to the ground line (e.g., 901 of FIG. 9) of the FPCB F1.

In an embodiment, the matching circuit 801 may include a switch 1010 and multiple matching elements 1020. The matching circuit 801 may select at least one or more of the multiple matching elements 1020 by controlling the switch 1010 under the control of the processor 120 or the communication processor 124. The multiple matching elements 1020 may have different impedance values, respectively. However, it is not limitative, and the matching circuit 801 may include a variable matching element. For example, the matching circuit 801 may have the matching value changed under the control of the processor 120 or the communication processor 124. The matching circuit 801 may include a variable impedance. For example, the matching circuit 801 may have the impedance value changed under the control of the processor 120 or the communication processor 124.

Referring to FIG. 5, FIG. 6, FIG. 7A, and FIG. 7B, harmonic frequency components having properties similar to the RF frequency operating in the electronic device 200 may be generated as noise by the length (or shape) of the FPCB F1. The length (or shape) of the FPCB F1 may be a length corresponding to one of the distance values between the first connector 701 and the second connector 703.

Referring to FIG. 5, FIG. 6, FIG. 7A, FIG. 7B, and FIG. 9, the electronic device 200 may include information on multiple RF frequencies available in the electronic device 200 in the memory 130.

In an embodiment, the electronic device 200 may include information on harmonic frequency components caused by the length (or shape) of the FPCB F1 corresponding to each of multiple RF frequencies available in the electronic device 200 in the memory 130.

In an embodiment, the electronic device 200 may store information on noises caused by the length (or shape) of the FPCB F1 corresponding to each of multiple RF frequencies available in the electronic device 200 in the memory 130.

In an embodiment, the electronic device 200 may change the impedance of the FPCB F1 by controlling the matching circuit 801, based on information on noises corresponding to each of multiple RF frequencies under the control of the processor 120.

In an embodiment, the electronic device 200 may include information that may be used to change the matching value or impedance value of the FPCB F1, based on information on noises corresponding to each of multiple RF frequencies in the memory 130.

In an embodiment, the electronic device 200 may control the electrical characteristics of the FPCB F1 to be changed, based on information on noises according to the length (or shape) of the FPCB F1 under the control of the processor 120.

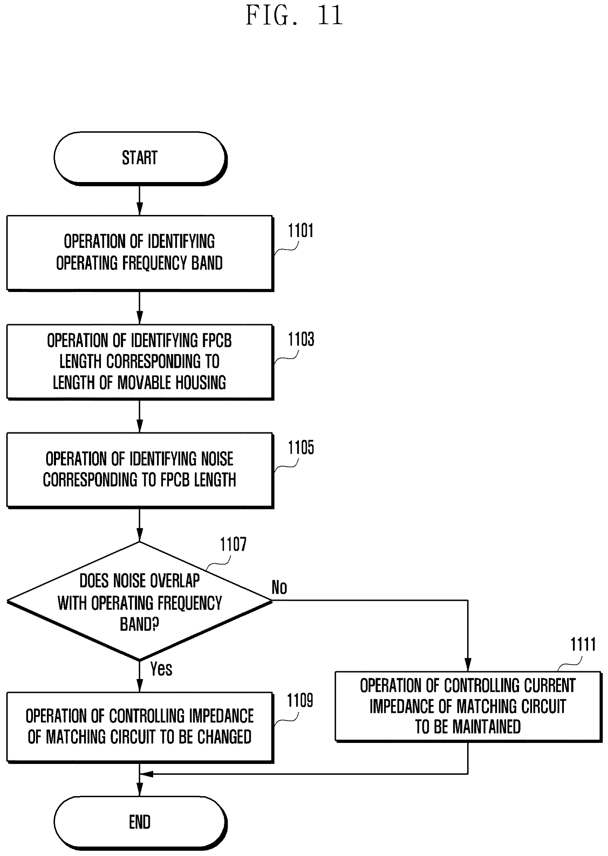

FIG. 11 is a flowchart of a noise control method by an electronic device 200 according to an embodiment of the disclosure.

In an embodiment, the electronic device 200 may identify the band of the RF frequency operating in the electronic device 200 or the communication processor 124 in operation 1101 under the control of the processor 120.

In an embodiment, the electronic device 200 may have a first housing 210 and a second housing 220 movably coupled, and the length (or shape) of the electronic device 200 may change according to movements of the first housing 210 and second housing 220. The display area of the flexible display 230 of the electronic device 200 may increase or decrease according to movements of the first housing 210 and second housing 220. The length (or shape) of the FPCB F1 of the electronic device 200, which electrically connects the first substrate 251 and second substrate 252, may change according to movements of the first housing 210 and second housing 220. The length (or shape) of the FPCB F1 may be a length corresponding to one of the distance values between the first connector 701 and the second connector 703.

In an embodiment, the electronic device 200 may include information on multiple RF frequencies available in the electronic device 200 in the memory 130.

In an embodiment, the electronic device 200 may identify the length (or shape) of the FPCB F1 corresponding to the length of the movable housings 210 and 220 in operation 1103 under the control of the processor 120. The length of the FPCB F1 may refer to a length corresponding to one of the distance values between the first connector 701 and the second connector 703. For example, as the first housing 210 and/or second housing 220 move, the distance between the first connector 701 and second connector 703 coupled to the substrates included in respective housings may change, and the length of the FPCB F1 may be one of the distance values between the first connector 701 and the second connector 703.

In an embodiment, the electronic device 200 may identify the distance between the first connector 701 and the second connector 703 corresponding to the length of the movable housings 210 and 220 in operation 1103 under the control of the processor 120.

In an embodiment, the sensor module 204, 217 may include a sensor capable of measuring the distance of movement of the housings 210 and 220.

In an embodiment, the electronic device 200 may determine the length of the movable housings 210 and 220 by using the sensor modules 204 and 217 in operation 1103 under the control of the processor 120, and may identify the length (or shape) of the FPCB F1 corresponding to the length of the movable housings 210 and 220 stored in the memory 130. The operation of determining the length of the movable housings 210 and 220 using the sensor modules 204 and 217 may be omitted.

In an embodiment, the electronic device 200 may identify noise corresponding to the length (or shape) of the FPCB F1 in operation 1105 under the control of the processor 120.

In an embodiment, the electronic device 200 may include information on harmonic frequency components caused by the length (or shape) of the FPCB F1 corresponding to each of multiple RF frequencies available in the electronic device 200 in the memory 130.

In an embodiment, the electronic device 200 may store information on noises caused by the length (or shape) of the FPCB F1 corresponding to each of multiple RF frequencies available in the electronic device 200 in the memory 130.

In an embodiment, the electronic device 200 may store information on noises caused by housing movements corresponding to multiple RF frequencies available in the electronic device 200, respectively, in the memory 130.

In an embodiment, the electronic device 200 may identify noise corresponding to the length (or shape) of the FPCB F1 with regard to each of multiple RF frequencies stored in the memory 130 in operation 1105 under the control of the processor 120.

In an embodiment, the electronic device 200 may identify noise corresponding to the length (or shape) of the FPCB F1 with regard to each of multiple RF frequencies stored in the memory 130 in operation 1105 under the control of the processor 120.

In an embodiment, the electronic device 200 may determine whether noise caused by the length (or shape) of the FPCB F1 overlaps or resonates with the RF frequency band operating in the electronic device 200 in operation 1107 under the control of the processor 120.

In an embodiment, the electronic device 200 may determine whether noise caused by a change in the distance between the first connector 701 and the second connector 703 according to housing movements overlaps or resonates with the RF frequency band operating in the electronic device 200 in operation 1107 under the control of the processor 120.

In an embodiment, if noise caused by the length (or shape) of the FPCB F1 overlaps or resonates with the RF frequency band operating in the electronic device 200, the electronic device 200 may proceed from operation 1107 to operation 1109.

In an embodiment, if noise caused by a change in the distance between the first connector 701 and the second connector 703 according to housing movements overlaps or resonates with the RF frequency band operating in the electronic device 200, the electronic device 200 may proceed from operation 1107 to operation 1109.

In an embodiment, if noise caused by the length (or shape) of the FPCB F1 does not overlap or resonate with the RF frequency band operating in the electronic device 200, the electronic device 200 may proceed from operation 1107 to operation 1111.

In an embodiment, if noise caused by a change in the distance between the first connector 701 and the second connector 703 according to housing movements does not overlap or resonate with the RF frequency band operating in the electronic device 200, the electronic device 200 may proceed from operation 1107 to operation 1111.

In an embodiment, the electronic device 200 may control the matching circuit 801 to change the impedance of the matching circuit 801 in operation 1109 under the control of the processor 120.

In an embodiment, the electronic device 200 may change the impedance of the FPCB F1 by controlling the matching circuit 801, based on information on noises corresponding to multiple RF frequencies, respectively, in operation 1109 under the control of the processor 120.

In an embodiment, the electronic device 200 may change the matching value or impedance value of the FPCB F l, based on information on noises corresponding to multiple RF frequencies, respectively, in operation 1109 under the control of the processor 120.

In an embodiment, the electronic device 200 may control the electrical characteristics of the FPCB F1 to be changed, based on information on noises according to the length (or shape) of the FPCB F1 in operation 1109 under the control of the processor 120.

In an embodiment, the electronic device 200 may control the electrical characteristics of the FPCB F1 to be changed, based on information on noises caused by a change in the distance between the first connector 701 and the second connector 703 according to housing movements in operation 1109 under the control of the processor 120.

In an embodiment, the electronic device 200 may control the matching circuit 801 to maintain the impedance of the matching circuit 801 in operation 1111 under the control of the processor 120.

In an embodiment, an electronic device (e.g., electronic device 200 or electronic device 101) may include a slidable housing including a first housing 210 and a second housing 220, a first substrate 251 included in the first housing 210 and including a processor (e.g., processor 120 or main processor 121), a second substrate included in the second housing 220, an FPCB F1 including a ground line, electrically connecting between the first substrate 251 and the second substrate, and having a shape changed according to a movement of the slidable housing, and a matching circuit 801 electrically connecting the first substrate 251 and at least a part of the ground line of the FPCB F1, and having an impedance changed under the control of the processor (e.g., processor 120 or main processor 121) according to a movement of at least a part of the housing.

In an embodiment, the electronic device (e.g., electronic device 200 or electronic device 101) may further include a memory 130 storing instructions.

In an embodiment, the memory 130 may store information on multiple radio frequency (RF) frequencies available in the electronic device (e.g., electronic device 200 or electronic device 101).

In an embodiment, the electronic device may include at least one sensor (e.g., sensor modules 204 and 217) for detecting movements of the slidable housing.

In an embodiment, the memory 130 may store information on the shape of the FPCB F1 corresponding to movements of the slidable housing.

In an embodiment, the memory 130 may store information on noises according to the shape of the FPCB F1 corresponding to multiple RF frequencies, respectively.

In an embodiment, the instructions, when executed by the processor (e.g., processor 120 or main processor 121), may cause the electronic device (e.g., electronic device 200 or electronic device 101) to identify the RF frequency band operating in the electronic device (e.g., electronic device 200 or electronic device 101) or the communication processor 124.

In an embodiment, the instructions, when executed by the processor (e.g., processor 120 or main processor 121), may cause the electronic device (e.g., electronic device 200 or electronic device 101) to identify information on the shape of the FPCB F1 corresponding to movements of the slidable housing.

In an embodiment, the instructions, when executed by the processor (e.g., processor 120 or main processor 121), may cause the electronic device (e.g., electronic device 200 or electronic device 101) to identify information on noises according to the shape of the FPCB F1 corresponding to multiple RF frequencies, respectively.

In an embodiment, the instructions, when executed by the processor (e.g., processor 120 or main processor 121), may cause the electronic device (e.g., electronic device 200 or electronic device 101) to determine whether noises according to the shape of the FPCB F1 overlap or resonate with the RF frequency band operating in the electronic device (e.g., electronic device 200 or electronic device 101) or the communication processor 124.

In an embodiment, the instructions, when executed by the processor (e.g., processor 120 or main processor 121), may cause the electronic device (e.g., electronic device 200 or electronic device 101) to control the matching circuit 801 to change the impedance of the matching circuit 801 in case that noises according to the shape of the FPCB F1 overlap or resonate with the RF frequency band operating in the electronic device (e.g., electronic device 200 or electronic device 101) or the communication processor 124.

In an embodiment, the instructions, when executed by the processor (e.g., processor 120 or main processor 121), may cause the electronic device (e.g., electronic device 200 or electronic device 101) to control the matching circuit 801 to change the impedance of the matching circuit 801 in case that noises according to movements of the slidable housing overlap or resonate with the RF frequency band operating in the electronic device (e.g., electronic device 200 or electronic device 101) or the communication processor 124.

In an embodiment, the instructions, when executed by the processor (e.g., processor 120 or main processor 121), may cause the electronic device (e.g., electronic device 200 or electronic device 101) to control the matching circuit 801 to maintain the impedance of the matching circuit 801 in case that noises according to the shape of the FPCB F1 do not overlap or resonate with the RF frequency band operating in the electronic device (e.g., electronic device 200 or electronic device 101) or the communication processor 124.

In an embodiment, the instructions, when executed by the processor (e.g., processor 120 or main processor 121), may cause the electronic device (e.g., electronic device 200 or electronic device 101) to control the matching circuit 801 to maintain the impedance of the matching circuit 801 in case that noises according to movements of the slidable housing do not overlap or resonate with the RF frequency band operating in the electronic device (e.g., electronic device 200 or electronic device 101) or the communication processor 124.

In an embodiment, the matching circuit 801 may include a switch controlled by the processor (e.g., processor 120 or main processor 121), multiple matching elements selected by the switch, or a variable impedance controlled by the processor (e.g., processor 120 or main processor 121).

In an embodiment, the FPCB F1 may further include a connector (e.g., first connector 701 or second connector 703) including a ground pin.

In an embodiment, the connector (e.g., first connector 701 or second connector 703) may electrically connect at least a part of the ground line and the matching circuit 801.

In an embodiment, a noise control method by an electronic device (e.g., electronic device 200 or electronic device 101) including a flexible printed circuit board (FPCB) F1 having a shape changed according to movements of a slidable housing may include an operation of identifying an RF frequency band operating in the electronic device (e.g., electronic device 200 or electronic device 101) or the communication processor 124, an operation of identifying information on the shape of the FPCB F1 corresponding to movements of the slidable housing, an operation of identifying information on noises according to the shape of the FPCB F1 corresponding to multiple RF frequencies, respectively, an operation of determining whether noises according to the shape of the FPCB F1 overlap or resonate with the RF frequency band operating in the electronic device (e.g., electronic device 200 or electronic device 101) or the communication processor 124, and an operation of controlling the matching circuit 801 to change the impedance of the matching circuit 801 in case that noises according to the shape of the FPCB F1 overlap or resonate with the RF frequency band operating in the electronic device (e.g., electronic device 200 or electronic device 101) or the communication processor 124.

In an embodiment, the noise control method by the electronic device (e.g., electronic device 200 or electronic device 101) may include an operation of controlling the matching circuit 801 to change the impedance of the matching circuit 801 in case that noises according to the shape of the FPCB F1 overlap or resonate with the RF frequency band operating in the electronic device (e.g., electronic device 200 or electronic device 101) or the communication processor 124.

In an embodiment, the noise control method by the electronic device (e.g., electronic device 200 or electronic device 101) may include an operation of controlling the matching circuit 801 to change the impedance of the matching circuit 801 in case that noises according to movements of the slidable housing overlap or resonate with the RF frequency band operating in the electronic device (e.g., electronic device 200 or electronic device 101) or the communication processor 124.

In an embodiment, the noise control method by the electronic device (e.g., electronic device 200 or electronic device 101) may include an operation of determining the length of at least one housing by using a sensor module (e.g., sensor module 204 or 217).

In an embodiment, the noise control method by the electronic device (e.g., electronic device 200 or electronic device 101) may include an operation of identifying information on the shape of the FPCB F1 corresponding to the length of at least one housing stored in the memory 130.

The electronic device according to various embodiments set forth herein may be one of various types of electronic devices. The electronic device may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that the embodiments and the terms used therein are not intended to limit the technological features set forth herein to particular embodiments and the disclosure includes various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one or all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used in various embodiments of the disclosure, the term "module" may include a unit implemented in hardware, software, or firmware, and may be interchangeably used with other terms, for example, "logic," "logic block," "component," or "circuit". The "module" may be a single integrated component, or a minimum unit or part thereof, adapted to perform one or more functions. For example, according to an embodiment, the "module" may be implemented in the form of an application-specific integrated circuit (ASIC).

Various embodiments as set forth herein may be implemented as software (e.g., the program 140) including one or more instructions that are stored in a storage medium (e.g., the internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, methods according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store TM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may be separately disposed in another element. According to various embodiments, one or more of the above-described elements or operations may be omitted, or one or more other elements or operations may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

## Claims

1. An electronic device comprising:
a housing comprising a first housing and a second housing, at least a part of the housing being movable;
a first substrate included in the first housing and comprising a processor;
a second substrate included in the second housing;
a flexible printed circuit board (FPCB) comprising a ground line and electrically connecting between the first substrate and the second substrate, a shape of the FPCB being changed according to a movement of the at least a part of the housing; and
a matching circuit configured to electrically connect the first substrate and at least a part of the ground line, and configured to change impedance under control of the processor according to a movement of at least a part of the housing.

2. The electronic device of claim 1, further comprising a memory configured to store instructions,
wherein the memory stores information on multiple radio frequency (RF) frequencies available in the electronic device.

3. The electronic device of claim 2, wherein the memory stores information on the shape of the FPCB corresponding to a movement of at least a part of the housing.

4. The electronic device of claim 2, wherein the memory stores information on noises according to the shape of the FPCB corresponding to the multiple RF frequencies, respectively.

5. The electronic device of claim 4, wherein the instructions, when executed by the processor, cause the electronic device to identify an RF frequency band operating in the electronic device or in a communication processor.

6. The electronic device of claim 5, wherein the instructions, when executed by the processor, cause the electronic device to:
identify information on the shape of the FPCB corresponding to a movement of the slidable housing;
identify information on noises according to the shape of the FPCB corresponding to the multiple RF frequencies, respectively; and
determine whether noises according to the shape of the FPCB overlap or resonate with the RF frequency band operating in the electronic device or the communication processor.

7. The electronic device of claim 6, wherein the instructions, when executed by the processor, cause the electronic device to control the matching circuit to change the impedance of the matching circuit in case that noises according to the shape of the FPCB overlap or resonate with the RF frequency band operating in the electronic device or the communication processor.

8. The electronic device of claim 6, wherein the instructions, when executed by the processor, cause the electronic device to control the matching circuit to maintain the impedance of the matching circuit in case that noises according to the shape of the FPCB do not overlap or resonate with the RF frequency band operating in the electronic device or the communication processor.

9. The electronic device of claim 1, wherein the matching circuit comprises:
a switch controlled by the processor;
multiple matching elements selected by the switch; or
a variable impedance controlled by the processor.

10. The electronic device of claim 1, wherein the FPCB further comprises a connector comprising a ground pin, and
wherein the connector electrically connects at least a part of the ground line and the matching circuit.

11. A noise control method of an electronic device comprising a flexible printed circuit board (FPCB) having a shape changed according to a movement of a slidable housing, the method comprising:
identifying an RF frequency band operating in the electronic device or a communication processor;
identifying information on the shape of the FPCB corresponding to a movement of the slidable housing;
identifying information on noises according to the shape of the FPCB corresponding to multiple RF frequencies, respectively;
determining whether noises according to the shape of the FPCB overlap or resonate with the RF frequency band operating in the electronic device or the communication processor; and
controlling a matching circuit to change impedance of the matching circuit in case that noises according to the shape of the FPCB overlap or resonate with the RF frequency band operating in the electronic device or the communication processor.

12. The method of claim 11, comprising controlling the matching circuit to change the impedance of the matching circuit in case that noises according to the shape of the FPCB overlap or resonate with the RF frequency band operating in the electronic device or the communication processor.

13. The method of claim 11, wherein the FPCB electrically connects between the first substrate and the second substrate, and has a shape changed according to a movement of the slidable housing.

14. The method of claim 11, wherein the identifying of information on the shape of the FPCB corresponding to a movement of at least one housing comprises determining the length of the at least one housing by using a sensor module.

15. The method of claim 14, wherein the identifying of information on the shape of the FPCB corresponding to a movement of the slidable housing further comprises identifying information on the shape of the FPCB corresponding to the length of the at least one housing stored in a memory.
